# EUROPÄISCHE PATENTSCHRIFT

(11) **EP 2 850 731 B1**
(45) Veröffentlichungstag und Bekanntmachung des Hinweises auf die Patenterteilung: **03.02.2016**
(21) Anmeldenummer: 13713145.4
(22) Anmeldetag: 25.03.2013
(51) Int. Cl.: H03M 1/00, H03M 1/06, H04B 1/00, G01B 9/02, G11B 27/36, H03M 1/12, H03M 1/18, H04L 25/00

(54) **VERFAHREN ZUR ENTSTÖRUNG EINES ABTASTPROZESSES SOWIE EINE VORRICHTUNG ZUR DURCHFÜHRUNG DES VERFAHRENS**
PROCEDURE FOR SUPRESSING A DISTURBANCE IN A SAMPLING PROCESS AND A DEVICE FOR EXECUTING THE PROCEDURE
PROCÉDURE POUR SUPPRIMER UNE PERTURBATION DANS UN PROCESSUS D'ÉCHANTILLONNAGE ET UN DISPOSITIF DE MISE EN OEUVRE DE LA PROCÉDURE

(30) Priorität: 16.05.2012 DE 102012208261
(43) Veröffentlichungstag der Anmeldung: 25.03.2015
(73) Patentinhaber: Robert Bosch GmbH, 70442 Stuttgart (DE)
(72) Erfinder: WUCHERT, Thomas, 36466 Dermbach (DE); KALISCH, Matthias, 70794 Filderstadt-Sielmingen (DE)
(86) Internationale Anmeldenummer: PCT/EP2013/056306
(87) Internationale Veröffentlichungsnummer: WO 2013/170991

(56) Entgegenhaltungen:
- EP-A1- 1 330 036
- DE-A1- 2 455 302
- DE-A1-102011 007 033
- US-A- 5 485 273
- US-A1- 2010 054 098
- BILINSKIS I ET AL: "DIGITAL ALIAS-FREE SIGNAL PROCESSING IN THE GHZ FREQUENCY RANGE", IEE COLLOQUIUM ON ADVANCED SIGNAL PROCESSING FOR MICROWAVEAPPLICATIONS, 29. November 1996 (1996-11-29), Seiten 6/01-6/06, XP001133893, IEE, LONDON, GB
- SJEF VAN ROOIJ: "DIGITAL SIGNAL PROCESSING: Kursteil 2: Abtasten und digitale Filtertechnik", ELEKTOR, 1. Februar 1998 (1998-02-01), Seiten 66-70, XP002697900, Germany
- MICHAEL HARTKOPF: "Digitale Audiosignale, Teil 1", FUNKSCHAU, 1. Februar 1997 (1997-02-01), Seite 2pp, XP002697901, Germany
- MICHAEL HARTKOPF: "Digitale Audiosignale, Teil 2", FUNKSCHAU, 1. April 1997 (1997-04-01), Seite 2pp, XP008163400, Germany

## Beschreibung

Die vorliegende Erfindung betrifft ein Verfahren zur Entstörung eines Abtastprozesses, bei dem in Abhängigkeit von dem Vorliegen eines bestimmt gearteten Störers im Basisband eines abgetasteten und analog-digital-gewandelten Signals eine sukzessive Veränderung der Abtastfrequenz vorgenommen wird.

### Stand der Technik

Zur digitalen Auswertung der Messergebnisse von Sensoren ist es notwendig, das analoge Sensorsignal beziehungsweise das von Sensoren abgetastete Signal in ein digitales Signal zu wandeln. Häufig werden hierfür Analog-Digital-Wandler eingesetzt, die die Vorteile einer Überabtastung nutzen. Hierbei wird das schmalbandige Eingangssignal mit einem hochfrequenten Takt abgetastet und anschließend mit einem Analog-Digital-Wandler digitalisiert. Die Bandbreite des Nutzsignals (auch als Nutzband oder Basisband bezeichnet) ist dabei deutlich kleiner als die halbe Abtastfrequenz. Enthält das Eingangssignal hochfrequente Störsignale, so werden diese aufgrund des Alias-Effekts gegebenenfalls in das Nutzband heruntergefaltet. Um dies zu verhindern, wird üblicherweise ein Anti-Aliasing-Filter verwendet, das die hochfrequenten Störsignale vor der Abtastung herausfiltert.

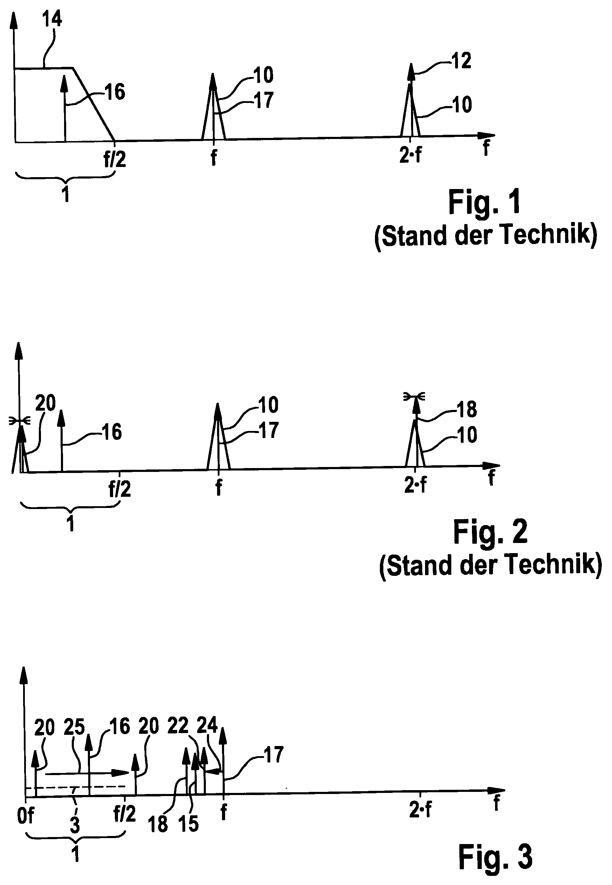

In Figur 1 ist schematisch ein Frequenzdiagramm für eine solche Situation dargestellt. Das analoge Nutzsignal 16 wird mit einer Abtastfrequenz f abgetastet. Bei einer idealisierten Schaltung beziehungsweise einem idealisierten Verfahren geschieht dies beispielsweise mit Hilfe eines periodischen Taktsignals mit der Periode T = 1/f, wobei jeweils zu einem bestimmten Zeitpunkt innerhalb der Periode, beispielsweise wenn das periodische Taktsignal eine bestimmte Spannung überschreitet oder unterschreitet, ein Abtastwert erfasst wird, so dass der zeitliche Abstand zwischen zwei aufeinander folgenden Abtastzeitpunkten jeweils der Periode T entspricht. Das abgetastete Nutzsignal ergibt sich dann in der Zeitdarstellung als Produkt des Eingangssignals mit einer Abtastfunktion, die durch eine Folge äquidistanter Abtastpulse im zeitlichen Abstand T gegeben ist. In der Frequenzdarstellung entspricht dieses Produkt einer Faltung des Frequenzspektrums des Eingangssignals mit dem Frequenzspektrum der Abtastfunktion, das durch eine Folge äquidistanter Spektrallinien im Abstand f gegeben ist. Das Frequenzspektrum 10 einer Abtastfunktion ist in Figur 1 dargestellt.

Das Eingangssignal kann überlagert hochfrequente Störsignale enthalten, wie sie beispielsweise bei elektromagnetischer Einkopplung auftreten. Gemäß dem Stand der Technik wird ein solches Störsignal vor dem Abtasten mit Hilfe eines Anti-Aliasing-Filters, beispielsweise eines Tiefpassfilters mit der Übertragungsfunktion 14, herausgefiltert. Ein solches, gefiltertes, hochfrequentes Störsignal 12 ist in Figur 1 beispielhaft bei einer Frequenz gezeigt, die knapp oberhalb des Zweifachen der Abtastfrequenz f liegt. Der Schnittpunkt der Übertragungsfunktion 14 des Anti-Aliasing-Filters mit der Frequenzachse begrenzt das Basisband 1 auf einen Bereich, der sich von 0*f bis zu einer Frequenz von f/2 erstreckt. Das Tiefpassfilter ist dabei so ausgebildet, dass ein analoges Nutzsignal 16 im Basisband 1 bei einer typischen Nutzfrequenz möglichst ungefiltert durchgelassen wird. Nachteilig an dieser Lösung ist, dass ein Anti-Aliasing-Filter implementiert werden muss. Insbesondere bei Realisierung auf einer anwendungsspezifischen integrierten Schaltung (ASIC) führt dies zu Entwicklungsaufwand und Flächenverbrauch.

Die Figur 2 zeigt die Frequenzspektren von der Abtastung eines analogen Nutzsignals 16 ohne Anti-Aliasing-Filter. Das Basisband 1 erstreckt sich wie im Falle der Filterung mit einem Anti-Aliasing-Filter über einen Frequenzbereich von 0*f bis f/2. Allerdings wird die Störamplitude 20, welche die Faltung eines ungefilterten, hochfrequenten Störers 18 im Fall der Abtastung ohne Verwendung des Anti-Aliasing-Filters darstellt, meist direkt in das Basisband 1 gefaltet und somit, bei der Abtastung mit einer Abtastfrequenz f, deren Frequenzspektrum 10 in Figur 2 gleich zu dem in Figur 1 eingezeichnet ist, fälschlicherweise als Nutzsignal 16 interpretiert.

In dem Artikel "Digital Alias-free signal processing in the GHz frequency Range" von I. Bilinksis, G. Cain, erschienen im Jahre 1996, Seiten 6/1 - 6/6 (XP1133893), beschreiben die Autoren ein von Aliasing befreites Abtastverfahren, bei welchem die Abtastzeitpunkte zeitlich um einen willkürlichen Zeitbetrag gegenüber einer periodischen Abtastung verschoben sind.

Ferner wird in der US 5,485,273 ein durch ein Ringlaser-Gyroskop verstärktes Auflösungssystem beschrieben, bei welchem eine der Abtastfrequenz-Modulation dienende Phase-locked-Loop-Schaltung mit einem schnellen Filter kombiniert zur Anwendung kommt.

Des Weiteren offenbart die EP 1 330 036 A1 ein Verfahren und eine Vorrichtung zur Alias-unterdrückten Digitalisierung von analogen Signalen hoher Frequenz, bei welchem ein Taktgeber eine Sequenz von elektrischen Pulsen einer predeterminierten Frequenz F_{clk} erzeugt, wobei die Sequenz zwecks Auswahl eines Pulses aus der Sequenz durch einen pseudo-willkürlichen Wert dividiert wird.

### Offenbarung der Erfindung

Erfindungsgemäß wird ein Verfahren zur Entstörung eines Abtastprozesses zur Verfügung gestellt, wobei das Verfahren die Verfahrensschritte des Abtastens eines analogen Signals mit einer Abtastfrequenz f sowie des Bestimmens, ob eine Störamplitude vorliegt, umfasst. Ferner umfasst das Verfahren den Schritt der Analog-Digital-Wandlung des abgetasteten Signals, wobei in dem Verfahrensschritt des Bestimmens, ob eine Störamplitude vorliegt, nur dann eine Störamplitude vorliegt, wenn diese größer als das Rauschen einer im Rahmen des Verfahrens durchgeführten Analog-Digital-Wandlung ist. Dabei liegt nur dann eine Störamplitude vor, wenn die Störamplitude im Basisband des Frequenzspektrums eines abgetasteten Nutzsignals vorliegt, wobei sich das Basisband über den Frequenzbereich von 0f bis f/2 erstreckt. Bei Vorliegen einer Störamplitude wird die Abtastfrequenz f vergrößert oder verkleinert und es beginnt das Verfahren erneut mit dem Verfahrensschritt des Abtastens des analogen Signals mit der vergrößerten oder verkleinerten Abtastfrequenz . Erfindungsgemäß erfolgt der Schritt des Vergrößerns oder Verkleinerns der Abtastfrequenz f sukzessive, um einen vorbestimmten, konstanten Betrag Δf, in eine Richtung mit immer gleichem Vorzeichen, bis zu einem Schwellwert f_{g}. Mit anderen Worten, bei Vorliegen eines Störers wird mit einer neuen, vergrößerten oder verkleinerten Abtastfrequenz abgetastet. Im anderen Fall wird weiter mit der ursprünglichen Abtastfrequenz f abgetastet.

Der Vorteil eines solchen Verfahrens ist darin gegeben, dass bei einer Analog-Digital-Wandlung, die auf einen Anti-Aliasing-Filter verzichtet, ein hochfrequenter Störer nicht mehr in das Basisband, sondern in einen Frequenzbereich gefaltet wird, welcher außerhalb des Basisbandes liegt. Somit kann das analog-digital-gewandelte Nutzsignal, durch die bloße Veränderung der Abtastfrequenz, richtig interpretiert und somit auf die Verwendung eines Anti-Aliasing-Filters verzichtet werden. Dadurch können Kosten sowie Platz bei der Implementierung eines Analog-Digital-Wandlers eingespart werden. Des Weiteren kommt es bei der Verwendung eines Anti-Aliasing-Filters auch zu einer unerwünschten Dämpfung des Nutzsignals, während nicht alle Frequenzanteile, die immer noch Alias-Effekte verursachen, durch das Anti-Aliasing-Filter unterdrückt werden können. Auch diese Nachteile lassen sich durch die Verwendung des erfindungsgemäßen Verfahrens umgehen.

Auf diese Weise wird das für die Interpretation des Nutzsignals unerhebliche Rauschen einer im Rahmen des Verfahrens angewandten Analog-Digital-Wandlung als Auslöser für eine Veränderung der Abtastfrequenz ausgeschlossen. Dadurch gewinnt das Verfahren an Effizienz, da eine Veränderung der Abtastfrequenz nur dann durchgeführt wird, wenn die Interpretation des Nutzsignals durch einen hochfrequenten Störer beziehungsweise eine Störamplitude beeinträchtigt ist.

Dadurch wird das Verfahren ausschließlich dann initiiert, wenn der Störer im Nutzband des Frequenzbereiches zum Tragen kommt, wodurch das Verfahren an Effizienz gewinnt.

Durch diese deterministische Änderung der Abtastfrequenz kann die Auswirkung des Verfahrens auf einen hochfrequenten Störer besser bestimmt beziehungsweise genauer geregelt werden, da die Veränderung der Abtastfrequenz linear, das heißt in äquidistanten Schritten erfolgt. Durch die Begrenzung der möglichen Veränderung der Abtastfrequenz über den Schwellwert f_{g} kann sichergestellt werden, dass das Verfahren nicht über einen sinnvollen Bereich hinaus ausgeführt wird, wodurch ein Verrauschen des Nutzsignals im Basisband verhindert wird.

In einer bevorzugten Weiterentwicklung dieser Ausführungsform wird Δf nach der folgenden, den Schwellwert f_{G} enthaltenden Vorschrift gebildet: f_{vergrößert/verkleinert} = f + Δf, wobei Δf = (f_{g}-f_{1,0})/n, n ∈ Z und f_{1,0} die anfängliche Abtastfrequenz ist.

In einer bevorzugten Weiterentwicklung dieser Ausführungsform ist der Schwellwert f_{G} durch den Wert des Aperture-Jitters einer im Rahmen des Abtastprozesses verwendeten Sample-And-Hold-Schaltung definiert. Damit ist der maximal mögliche Schwellwert f_{g} für das Verfahren gewählt, was den weitesten Spielraum für eine Veränderung der Abtastfrequenz bedeutet.

In einer bevorzugten Ausführungsform entspricht der Schwellwert f_{G} maximal der um 5 % vergrößerten oder verringerten anfänglichen Abtastfrequenz.

In einer bevorzugten Ausführungsform entspricht der Schwellwert f_{G} maximal der um 1 % vergrößerten oder verringerten anfänglichen Abtastfrequenz.

Vorzugsweise ist n aus einer Teilmenge der ganzen Zahlen M gewählt, mit M ∈ [1, 20]. Mit einer solchen Wahl des Parameters n wird die Zahl der möglichen Veränderungsschritte auf eine schaltungstechnisch vorteilhaft zu realisierende Anzahl von Schritten begrenzt. Noch bevorzugter gilt M ∈ [2,10].

Des Weiteren wird eine Vorrichtung bereitgestellt, welche einen Taktgeber umfasst, der zur Erzeugung eines periodischen Taktsignals und zur Veränderung der Periode des periodischen Taktsignals bei Empfang eines Steuersignals ausgelegt ist. Ferner umfasst die Vorrichtung ein Mittel zur Abtastung, welches dazu ausgelegt ist, das periodische Taktsignal zur Abtastung eines analogen Nutzsignals zu verwenden und ein abgetastetes Nutzsignal zu erzeugen. Des Weiteren ist ein Analog-Digital-Wandler dazu ausgelegt, das abgetastete Nutzsignal in ein digitales Nutzsignal zu wandeln.

Ein Mittel zur Störamplitudenbestimmung ist dazu ausgelegt zu bestimmen, ob dass digitale Nutzsignal mit einer Störamplitude beaufschlagt ist. Dabei liegt nur dann eine Störamplitude vor, wenn diese größer als das Rauschen der durchgeführten Analog-Digital-Wandlung ist und wenn die Störamplitude im Basisband des Frequenzspektrums des abgetasteten Nutzsignals vorliegt, wobei sich das Basisband über einen Frequenzbereich von 0*f bis f /2 erstreckt, Bei Vorliegen einer Störamplitude wird von dem Mittel zur Störamplitudenbestimmung ein Steuersignal generiert und dem Taktgeber zugeführt, derart dass, eine Änderung der Abtastfrequenz f im Mittel zur Abtastung sukzessive, um einen vorbestimmten, konstanten Betrag Δf in eine Richtung mit immer gleichem Vorzeichen, bis zu einem Schwellwert f_{g} erfolgt.

### Zeichnungen

Ausführungsbeispiele der Erfindung werden anhand der Zeichnungen und der nachfolgenden Beschreibung näher erläutert. Es zeigen:
Figur 1 die Frequenzspektren von der Abtastung eines Nutzsignals mit Anti-Aliasing-Filter des Standes der Technik,
Figur 2 die Frequenzspektren von der Abtastung eines Nutzsignals ohne Anti-Aliasing-Filter des Standes der Technik,
Figur 3 die Frequenzspektren von einer speziellen Abtastung eines Nutzsignals mit dem erfindungsgemäßen Verfahren,
Figur 4 einen prinzipiellen Aufbau einer Vorrichtung zur Durchführung des erfindungsgemäßen Verfahrens, und
Figur 5 eine prinzipielle, spezielle Ausführungsform einer Vorrichtung zur Durchführung des erfindungsgemäßen Verfahrens.

### Ausführungsformen der Erfindung

In der Figur 3 sind die Frequenzspektren von einer speziellen Abtastung eines Nutzsignals unter Verwendung des erfindungsgemäßen Verfahrens aufgezeigt. Das Basisband 1 erstreckt sich über den Frequenzbereich von 0f bis f/2. Ein analoges Nutzsignal 16 wird mit einer ersten Abtastfrequenz 17 abgetastet. Liegt die Störamplitude 20 eines hochfrequenten, ungefilterten Störers 18 vor, wird diese Störamplitude 20 im Rahmen des erfindungsgemäßen Verfahrens erkannt. Dann wird verfahrensgemäß eine Veränderung 24 der Abtastfrequenz 17 auf eine vergrößerte oder verkleinerte Abtastfrequenz 22 vorgenommen, und das Verfahren mit der vergrößerten oder verkleinerten Abtastfrequenz 22 erneut mit dem Verfahrensschritt des Abtastens des analogen Nutzsignals 16 begonnen (nicht dargestellt). Eine Störamplitude 20 wird nur dann erkannt, wenn diese größer als das Rauschen 3 einer im Rahmen des Verfahrens durchgeführten Analog-Digital-Wandlung ist, und die Störamplitude 20 zusätzlich im Basisband 1 zum Liegen kommt. Die Störamplitude 20 wird erkannt und in dem vorliegenden Ausführungsbeispiel die Abtastfrequenz 17 auf eine Abtastfrequenz 22 verringert. Dadurch kommt es zu einer Verschiebung 25 der zuvor in das Basisband 1 gefalteten Störamplitude 20 des hochfrequenten, ungefilterten Störers 18 in einen Frequenzbereich, der außerhalb des Basisbandes 1 liegt. Die Veränderung von der Abtastfrequenz 17 auf die Abtastfrequenz 22 erfolgt dabei sukzessive, um einen vorbestimmten, konstanten Betrag in eine Richtung mit immer gleichem Vorzeichen solange, bis die Störamplitude 20 des hochfrequenten, ungefilterten Störers 18 nicht mehr erkannt wird, sie also nicht mehr in das Basisband 1, sondern in einen Frequenzbereich abseits des Basisbandes 1 gefaltet wird. In diesem Fall besteht die Veränderung 24 von der Abtastfrequenz 17 zu der verkleinerten Abtastfrequenz 22 hin aus einer Vielzahl, zum Beispiel n, determinierter, konstanter Veränderungsschritte in immer eine Richtung mit gleichem, in Figur 3 negativem Vorzeichen. Dabei kann der Betrag der Veränderung 24 der Abtastfrequenz 17, also der Betrag von deren Vergrößerung oder, wie hier vorliegend, Verkleinerung durch einen Schwellwert 15 begrenzt sein, über den hinaus keine weitere Veränderung der Abtastfrequenz vorgenommen wird. Der Schwellwert 15 kann sich dabei an dem Aperture-Jitter einer im Rahmen des Verfahrens verwendeten Sample-And-Hold-Schaltung orientieren, aber auch auf einen Wert von um maximal X %, bevorzugt 1 % oder 5 % vergrößerten oder verringerten anfänglichen Abtastfrequenz 17 begrenzt sein. Die Dimensionierung des Betrages, um den die Veränderung 24 der Abtastfrequenz 17 auf die Abtastfrequenz 22, sukzessive, in immer die gleiche Richtung bis maximal zu dem Schwellwert 15 selbst erfolgt, kann beispielsweise auch unter Verwendung des gewählten beziehungsweise eingestellten Schwellwertes 15 über eine Bildungsvorschrift vorgenommen werden, bei welcher die Differenz aus dem Schwellwert 15 und der ersten Abtastfrequenz in n Teilschritte zerlegt wird.

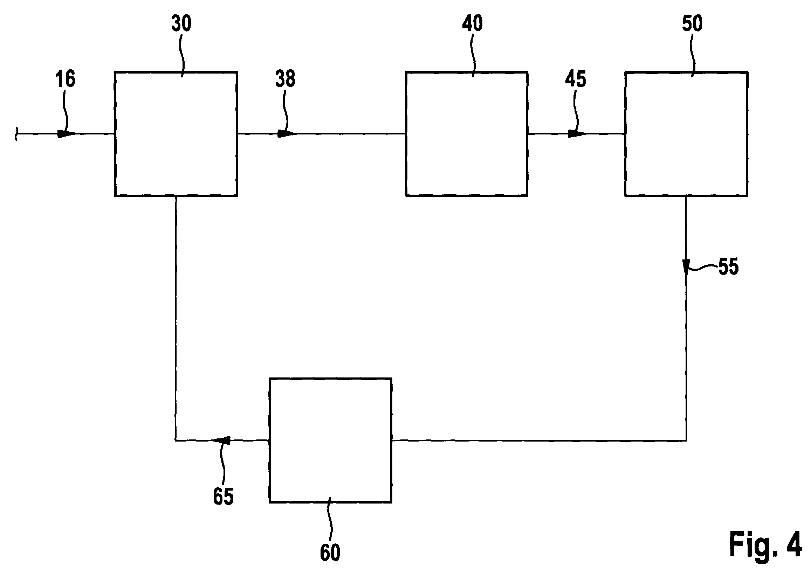

In der Figur 4 ist ein prinzipieller Aufbau einer Vorrichtung zur Durchführung des erfindungsgemäßen Verfahrens dargestellt. In dieser aufgeführt ist ein Taktgeber 60, welcher zur Erzeugung eines periodischen Taktsignals 65 und zur Veränderung der Periode des periodischen Taktsignals 65 bei Empfang eines Steuersignals 55 ausgelegt ist. Das periodische Taktsignal 65 wird einem Mittel zur Abtastung 30 bereitgestellt, in welchem das periodische Taktsignal 65 zur Abtastung eines analogen Nutzsignals 16 verwendet wird. Das Mittel zur Abtastung 30 ist ferner dazu ausgelegt, ein abgetastetes Nutzsignal 38 zu erzeugen und dieses einem Analog-Digital-Wandler 40 bereitzustellen. Der Analog-Digital-Wandler 40 ist dazu ausgelegt, das abgetastete Nutzsignal 38 in ein digitales Nutzsignal 45 zu wandeln und einem Mittel zur Störamplituden-Bestimmung 50 zuzuführen. In diesem Mittel zur Störamplituden-Bestimmung 50 wird bestimmt, ob das digitale Nutzsignal 45 mit einer Störamplitude 20 beaufschlagt ist, beziehungsweise, ob eine Störamplitude 20 vorliegt. Bei Vorliegen einer Störamplitude 20 wird in dem Mittel zur Störamplituden-Bestimmung 50 ein Steuersignal 55 generiert und dem Taktgeber 60 zugeführt, welcher daraufhin die Periode des periodischen Taktsignals 65 verändert. Liegt keine Störamplitude 20 vor, wird kein Steuersignal 55 generiert. Das Mittel zur Abtastung 30, der Analog-Digital-Wandler 40, das Mittel zur Störamplituden-Bestimmung 50 und der Taktgeber 60 bilden somit einen geschlossenen Regelkreis. In der hier abgebildeten Vorrichtung sind der Taktgeber 60, das Mittel zur Abtastung 30, der Analog-Digital-Wandler 40 und das Mittel zur Störamplituden-Bestimmung 50 als voneinander getrennte Einheiten beziehungsweise Komponenten dargestellt. Diese Komponenten können aber auch in beliebiger Art und Weise sowohl räumlich als auch funktional miteinander kombiniert sein. So kann rein beispielhaft sowohl die Abtastung als auch die Analog-Digital-Wandlung in einem Element erfolgen.

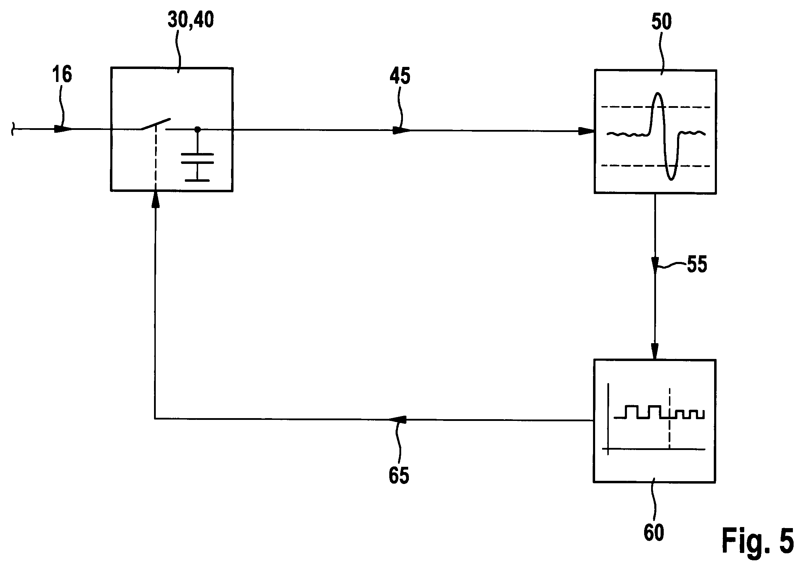

Die Figur 5 zeigt eine prinzipielle, spezielle Ausführungsform einer Vorrichtung zur Durchführung des erfindungsgemäßen Verfahrens. Abgebildet sind ein Analog-Digital-Wandler 40 sowie ein Mittel zur Abtastung 30, welche als eine funktionale Einheit zur Analog-Digital-Wandlung 30, 40 dargestellt sind. Das Mittel zur Abtastung 30 ist dabei als Sample-And-Hold-Schaltung ausgeführt, deren Schaltmittel sowie Haltekondensator schematisch in Figur 5 angedeutet sind. Die funktionale Einheit zur Analog-Digital-Wandlung 30, 40 ist mit einem Mittel zur Störamplituden-Bestimmung 50 verbunden, welches in diesem Ausführungsbeispiel als Digitalteil mit digitalem Komparator realisiert ist. Das Digitalteil ist wiederum mit einem Taktgeber 60, der als Oszillator ausgeführt ist, verbunden, während der Taktgeber 60 mit der funktionalen Einheit zur Analog-Digital-Wandlung 30, 40 verbunden ist. Damit liegt ein geschlossener Regelkreis über die funktionale Einheit zur Analog-Digital-Wandlung 30, 40, den Taktgeber 60 sowie das Mittel zur Störamplituden-Bestimmung 50 vor. Im Oszillator wird ein periodisches Taktsignal 65 mit der Periode T und der Frequenz f = 1/T erzeugt. Dieses periodische Taktsignal 65 wird der Sample-And-Hold-Schaltung zugeführt, und dazu verwendet, das Schaltmittel der Sample-And-Hold-Schaltung mit der Frequenz f zu öffnen und zu schließen. Wird der Sample-And-Hold-Schaltung zusätzlich zu dem periodischen Taktsignal 65 ein analoges Nutzsignal 16 zugeführt, so wird dieses analoge Nutzsignal 16 mit einer ersten Abtastfrequenz 17, welche der oben angeführten Frequenz f entspricht, abgetastet und, ebenfalls in der funktionalen Einheit zur Analog-Digital-Wandlung 30, 40, analog-digital-gewandelt. Am Ausgang der funktionalen Einheit zur Analog-Digital-Wandlung 30, 40 liegt ein digitales Nutzsignal 45 vor, welches dem Digitalteil zugeführt wird. In dem digitalen Komparator des Digitalteils wird das digitale Nutzsignal 45 mit mindestens einem Referenzwert verglichen, der beispielsweise dem Wert der durchschnittlichen Amplitude des Rauschens 3 der vorgelagerten Analog-Digital-Wandlung entspricht. Ist das digitale Nutzsignal 45 größer als der mindestens eine Referenzwert, so wird in dem Digitalteil ein Steuersignal 55, bevorzugt zum Beispiel ein 10-Bit-Trimming-Signal generiert und dem Oszillator zugeführt. In diesem wird die Periode des periodischen Taktsignals 65 dann entsprechend dem Steuersignal 55, hin zu einer vergrößerten oder verkleinerten Abtastfrequenz 22 verändert. Aus dem in Figur 5 schematisch angedeuteten Taktverlauf (auf dem Funktionsblock des Oszillators) kann ersehen werden, dass die Abtastfrequenz 22 größer als die Abtastfrequenz 17 ist. Die Abtastfrequenz wird so lange angepasst, bis das digitale Nutzsignal 45 kleiner als der mindestens eine Referenzwert des digitalen Komparators des Digitalteils 50 ist oder ein bestimmter Schwellwert 15 der maximalen Frequenzveränderung erreicht ist.

Im Übrigen kann in allen Ausführungsbeispielen bei Erreichen des Schwellwerts 15, zum Beispiel einer um X % vergrößerten anfänglichen Abtastfrequenz 17, das Verfahren bei einer um X % verkleinerten anfänglichen Abtastfrequenz 17 erneut beginnen, so dass die Abtastfrequenz trotz Vorliegens einer Störamplitude 20 im Basisband 1, in einer Schleife, kontinuierlich verändert wird. Bei Erreichen eines Schwellwerts 15 von zum Beispiel einer um X % verkleinerten anfänglichen Abtastfrequenz 17 beginnt das Verfahren bei einer um X % vergrößerten anfänglichen, Abtastfrequenz 17 entsprechend.

### Referenzzeichenliste:

- 16: analoges Nutzsignal
- 30: Mittel zur Abtastung
- 38: abgetastetes Nutzsignal
- 40: Analog-Digital-Wandler
- 45: digitales Nutzsignal
- 50: Mittel zur Störamplitudenbestimmung
- 55: Steuersignal
- 60: Taktgeber
- 65: periodisches Taktsignal

## Patentansprüche

1. Verfahren zur Entstörung eines Abtastprozesses, wobei das Verfahren die folgenden Verfahrensschritte umfasst:
Abtasten eines analogen Nutzsignals (16) mit einer Abtastfrequenz f (17);
Analog-Digital-Wandlung des abgetasteten Nutzsignals (38), Bestimmen, ob eine Störamplitude (20) vorliegt, wobei nur dann eine Störamplitude (20) vorliegt, wenn diese größer als das Rauschen (3) der im Rahmen des Verfahrens durchgeführten Analog-Digital-Wandlung ist und wenn die Störamplitude (20) im Basisband (1) des Frequenzspektrums des abgetasteten Nutzsignals (38) vorliegt, wobei sich das Basisband (1) über einen Frequenzbereich von 0*f bis f /2 erstreckt, ;
bei Vorliegen einer Störamplitude (20), Vergrößerung oder Verkleinerung der Abtastfrequenz f(17), wobei dann das Verfahren erneut mit dem Verfahrensschritt des Abtastens des analogen Nutzsignals (16) mit der vergrößerten oder verkleinerten Abtastfrequenz (17) beginnt,
**dadurch gekennzeichnet, dass**
der Schritt des Vergrößerns oder Verkleinerns der Abtastfrequenz f (17) sukzessive, um einen vorbestimmten, konstanten Betrag Δf in eine Richtung mit immer gleichem Vorzeichen, bis zu einem Schwellwert f_{g} (15) erfolgt.

2. Verfahren nach Anspruch 1, wobei Δf nach der folgenden, den Schwellwert f_{G} (15) enthaltenden Vorschrift gebildet wird: f_{vergrößert/verkleinert} = f + Δf, wobei Δf = (f_{g}-f_{1,0})/n, n ∈ Z und f_{1,0} die anfängliche Abtastfrequenz ist.

3. Verfahren nach einem der vorhergehenden Ansprüche, wobei der Schwellwert f_{G} (15) durch den Wert des Aperture-Jitters einer im Rahmen des Abtastprozesses verwendeten Sample-And-Hold-Schaltung definiert ist.

4. Verfahren nach einem der vorhergehenden Ansprüche, wobei der Schwellwert f_{G} (15) maximal der um 5 % vergrößerten oder verringerten anfänglichen Abtastfrequenz (17) entspricht.

5. Verfahren nach einem der vorhergehenden, wobei der Schwellwert f_{G} (15) maximal der um 1 % vergrößerten oder verringerten anfänglichen Abtastfrequenz (17) entspricht.

6. Verfahren nach Anspruch 2, wobei n aus einer Teilmenge der ganzen Zahlen M gewählt ist, mit M ∈ [1, 20].

7. Vorrichtung, umfassend
einen Taktgeber (60), welcher zur Erzeugung eines periodischen Taktsignals (65) und zur Veränderung der Periode des periodischen Taktsignals (65) bei Empfang eines Steuersignals (55) ausgelegt ist,
ein Mittel zur Abtastung (30), welches dazu ausgelegt ist, das periodische Taktsignal (65) als eine Abtastfrequenz f zur Abtastung eines analogen Nutzsignals (16) zu verwenden und ein abgetastetes Nutzsignal (38) zu erzeugen,
einen Analog-Digital-Wandler (40), dazu ausgelegt, das abgetastete Nutzsignal (38) in ein digitales Nutzsignal (45) zu wandeln,
ein Mittel zur Störamplitudenbestimmung (50), welches dazu ausgelegt ist zu bestimmen, ob dass digitale Nutzsignal (45) mit einer Störamplitude (20) beaufschlagt ist, wobei nur dann eine Störamplitude (20) vorliegt, wenn diese größer als das Rauschen (3) der durchgeführten Analog-Digital-Wandlung ist und wenn die Störamplitude (20) im Basisband (1) des Frequenzspektrums des abgetasteten Nutzsignals (38) vorliegt, wobei sich das Basisband (1) über einen Frequenzbereich von 0*f bis f /2 erstreckt, **dadurch gekennzeichnet, dass**
bei Vorliegen einer Störamplitude (20) von dem Mittel zur Störamplitudenbestimmung ein Steuersignal (55) generiert und dem Taktgeber (60) zugeführt wird, derart dass, eine Änderung der Abtastfrequenz f (17) im Mittel zur Abtastung sukzessive, um einen vorbestimmten, konstanten Betrag Δf in eine Richtung mit immer gleichem Vorzeichen, bis zu einem Schwellwert f_{g} (15) erfolgt.

## Claims

1. Method for suppressing interference in a sampling process, the method comprising the following method steps of:
sampling an analogue useful signal (16) at a sampling frequency f (17);
subjecting the sampled useful signal (38) to analogue/digital conversion,
determining whether an interference amplitude (20) is present, an interference amplitude (20) being present only when it is greater than the noise (3) in the analogue/digital conversion carried out as part of the method and when the interference amplitude (20) is present in the baseband (1) of the frequency spectrum of the sampled useful signal (38), the baseband (1) extending over a frequency range of 0*f to f/2,
if an interference amplitude (20) is present, increasing or reducing the sampling frequency f (17), the method then beginning again with the method step of sampling the analogue useful signal (16) at the increased or reduced sampling frequency (17),
**characterized in that**
the step of increasing or reducing the sampling frequency f (17) is carried out gradually by a predetermined constant magnitude Δf in a direction with always the same sign up to a threshold value f_{g} (15).

2. Method according to Claim 1, Δf being formed according to the following rule containing the threshold value f_{G} (15) : f_{increased/reduced} = f + Δf, where Δf = (f_{g}-f_{1,0})/n, n ∈ Z and f_{1,0} is the initial sampling frequency.

3. Method according to one of the preceding claims, the threshold value f_{G} (15) being defined by the value of the aperture jitter of a sample-and-hold circuit used as part of the sampling process.

4. Method according to one of the preceding claims, the threshold value f_{G} (15) corresponding at most to the initial sampling frequency (17) increased or reduced by 5%.

5. Method according to one of the preceding, the threshold value f_{G} (15) corresponding at most to the initial sampling frequency (17) increased or reduced by 1%.

6. Method according to Claim 2, n being selected from a subset of the integers M, with M ∈ [1, 20].

7. Apparatus comprising
a clock generator (60) which is designed to generate a periodic clock signal (65) and to change the period of the periodic clock signal (65) upon receiving a control signal (55),
a sampling means (30) which is designed to use the periodic clock signal (65) as a sampling frequency f for sampling an analogue useful signal (16) and to generate a sampled useful signal (38),
an analogue/digital converter (40) designed to convert the sampled useful signal (38) into a digital useful signal (45),
an interference amplitude determination means (50) which is designed to determine whether an interference amplitude (20) has been applied to the digital useful signal (45), an interference amplitude (20) being present only when it is greater than the noise (3) in the analogue/digital conversion carried out and when the interference amplitude (20) is present in the baseband (1) of the frequency spectrum of the sampled useful signal (38), the baseband (1) extending over a frequency range of 0*f to f/2, **characterized in that**
if an interference amplitude (20) is present, a control signal (55) is generated by the interference amplitude determination means and is supplied to the clock generator (60) in such a manner that the sampling frequency f (17) is gradually changed in the sampling means by a predetermined constant magnitude Δf in a direction with always the same sign up to a threshold value f_{g} (15).

## Revendications

1. Procédé de déparasitage d'une opération d'échantillonnage, le procédé comportant les étapes suivante :
échantillonnage d'un signal analogique utile (16) à une fréquence d'échantillonnage f (17),
conversion analogique-numérique du signal utile échantillonné (38),
détermination de la présence éventuelle d'une amplitude parasite (20), une amplitude parasite (20) étant présente uniquement si cette dernière est plus élevée que le bruit (3) de la conversion analogique-numérique exécutée dans le cadre du procédé et si l'amplitude parasite (20) est présente dans la bande de base (1) du spectre de fréquence du signal utile échantillonné (38), la bande de base (1) s'étendant sur une plage de fréquence de 0*f à f/2,
dans le cas de la présence d'une amplitude parasite (20), augmentation ou diminution de la fréquence d'échantillonnage f (17), le procédé reprenant alors l'étape d'échantillonnage du signal analogique utile (16) à la fréquence d'échantillonnage (17) augmentée ou diminuée,
**caractérisé en ce que**
l'étape d'augmentation ou de diminution de la fréquence d'échantillonnage f (17) s'effectue par étapes successives d'un pas Δf constant et prédéterminé dans une direction qui présente toujours le même signe et ce jusqu'à une valeur de seuil f_{g} (15).

2. Procédé selon la revendication 1, dans lequel Δf est formé par la condition suivante qui contient la valeur de seuil f_{G} (15) : f_{agrandi/diminué} = f + Δf, Δf = (f_{g}-f_{1,0})/n, n € Z et f_{1,0} étant la fréquence d'échantillonnage initiale.

3. Procédé selon l'une des revendications précédentes, dans lequel la valeur de seuil f_{G} (15) est définie par la valeur du sautillement d'ouverture d'un circuit d'échantillonnage et de maintien utilisé dans le cadre de l'opération d'échantillonnage.

4. Procédé selon l'une des revendications précédentes, dans lequel la valeur de seuil f_{G} (15) correspond au plus à la fréquence initiale d'échantillonnage (17) augmentée ou diminuée de 5 %.

5. Procédé selon l'une des précédentes, dans lequel la valeur de seuil f_{G} (15) correspond au plus à la fréquence initiale d'échantillonnage (17) augmentée ou diminuée de 1 %.

6. Procédé selon la revendication 2, dans lequel n est sélectionné parmi une partie de l'ensemble des nombres entiers M, avec M € [1, 20].

7. Ensemble comprenant :
une horloge de cadençage (60) conçue pour former un signal périodique d'horloge (65) et pour modifier la période du signal périodique d'horloge (65) lors de la réception d'un signal de commande (55),
un moyen d'échantillonnage (30) conçu pour utiliser le signal périodique d'horloge (65) comme fréquence d'échantillonnage f destiné à échantillonner un signal analogique utile (16) et à former un signal utile échantillonné (38),
un convertisseur analogique-numérique (40) conçu pour convertir le signal utile échantillonné (38) en un signal utile numérique (45),
un moyen (50) de détermination d'une amplitude parasite conçu pour déterminer si le signal numérique utile (45) est affecté d'une amplitude parasite (20), une amplitude parasite (20) n'étant présente que si elle est supérieure au bruit (3) de la conversion analogique-numérique exécutée et si l'amplitude parasite (20) est située dans la base de bande (1) du spectre de fréquence du signal utile échantillonné (38), la bande de base (1) s'étendant sur une plage de fréquence de 0*f à f/2,
**caractérisé en ce que**
dans le cas de la présence d'une amplitude parasite (20), un signal de commande (55) est formé par le moyen de détermination d'amplitude parasite et est amené à l'horloge de cadençage (60) de manière à obtenir une modification de la fréquence d'échantillonnage f (17) dans le moyen d'échantillonnage par étapes successives d'un pas Δf constant et prédéterminé dans une direction qui présente toujours le même signe et ce jusqu'à une valeur de seuil f_{g} (15).
